Europäisches Patentamt

(19) European Patent Office

Office européen des brevets

(11) Publication number: **0 153 401**
**B1**

(12) **EUROPEAN PATENT SPECIFICATION**

(45) Date of publication of patent specification: **27.07.88**

(21) Application number: **84903282.6**

(22) Date of filing: **17.08.84**

(86) International application number:
**PCT/FI84/00056**

(87) International publication number:
**WO 85/00894 28.02.85 Gazette 85/05**

(51) Int. Cl.⁴: **G 01 R 11/17**

(54) **STATIC KWH METER.**

(30) Priority: **18.08.83 FI 832961**

(43) Date of publication of application:
**04.09.85 Bulletin 85/36**

(45) Publication of the grant of the patent:
**27.07.88 Bulletin 88/30**

(84) Designated Contracting States:
**AT CH DE FR GB LI NL SE**

(56) References cited:
**DE-A-2 619 734**
**US-A-3 794 917**
**US-A-4 217 546**
**US-A-4 315 212**

(73) Proprietor: **Valmet Oy**
**Punanotkonkatu 2**
**SF-00130 Helsinki 13 (FI)**

(72) Inventor: **LAHTI, Teuvo**
**Gummeruksenkatu 13 B 24**
**SF-40100 Jyväskylä (FI)**

(74) Representative: **Grupe, Peter, Dipl.-Ing. et al**
**Patentanwaltsbüro Tiedtke-Bühling-Kinne-**
**Grupe-Pellmann-Grams-Struif Bavariaring 4**
**D-8000 München 2 (DE)**

Courier Press, Leamington Spa, England.

## Description

The present invention concerns a static kWh meter, according to the preamble of Claim 1.

Static kWh meters based on a pluse width-pulse height multiplicator, i.e., on a time-chopping multiplicator, are commonly known in the art, and as examples of existing design solutions may be mentioned the U.S. Patents US—A—4,315,212 and US—A—3,794,917.

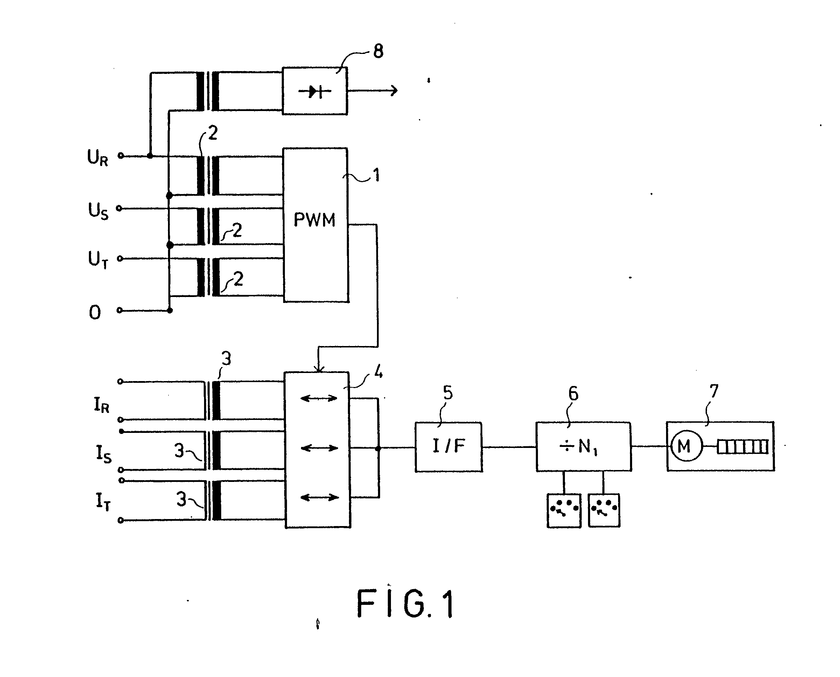

The main components of a three-phase meter of this type known in prior art are presented in the block diagram of Figure 1. In the meter, a sample pulse sequence is formed in which the width of the pulses is proportional to the momentary value of the voltage and the height of the pulses is proportional to the momentary value of the current, so that the area subtended by the pulse is proportional to the product of voltage and current, i.e., to the power. The sample pulse frequency is selected to be approximately ten times higher than the mains frequency in order to account for superharmonics as well. The signal modulating the pulse width modulator 1, is a signal proportional to the mains voltage, produced by the aid of voltage transformers 2. In meters known in the art, the pulse width modulation has usually been carried out by means of an operational amplifier acting as a comparator, to one input terminal thereof being conducted a triangular wave and to the other input terminal a modulating signal proportional to the voltage. The threshold level of the comparator is controlled by the modulating voltage, and at the output of the comparator is obtained a square wave having the same frequency as the triangular wave but dependent on the value of the control voltage, as regards its pulse proportions. By the pulse width-modulated square wave obtained are controlled analog switches 4 in the secondary circuits of the current measuring transformers 3, from their outputs being obtained pulses with a height proportional to the current in the measuring circuit, and which are still modulated by the mains voltage as regards their width. The pulses are filtered so as to obtain a d.c. voltage proportional to the power, and this voltage is supplied to a voltage/frequency converter 5. The voltage/frequency converter 5 consists of an integrator amplifier integrating the output of the multiplicator and a threshold level detector, which initiates a new cycle when the output of the integrator exceeds the threshold level of the detector. Thus, the output of the converter delivers a pulse frequency which is proportional to the d.c. voltage supplied thereto, that is to the power, and by which the step motor actuating the counter means 7 of the meter is controlled over a divider unit 6. The counter means integrates the power, in other words, it displays the energy consumed. For the power supply of the circuits of the meter, a power source 8 is moreover provided, producing the operating voltage from the mains voltage.

It is thus noticed that in static kWh meters known in the art the multiplicator circuits as well as the voltage/frequency converter comprise operational amplifiers the offset voltages of which exert an influence on the result of measurement. This objectionable phenomenon is particularly apparent in the product from the voltage/frequency converter when the input voltage of the integrator is low. In practice, the input voltage may be on the same order of magnitude as the offset voltage of the operator amplifier, whereby quite large errors of the measuring result are possible. In addition, the offset voltage is a function of time and temperature, thereby interfering with the maintaining of perfect offset voltage compensation in kWh meters of prior art.

The object of the present invention is to solve the problems stated above and to accomplish a static kWh meter in a simple manner so that the harmful effect of the offset voltage due to the use of an operator amplifer on the accuracy of the voltage/frequency converter will be compensated.

As taught by the invention, the task has been accomplished by the features mentioned in the characterising part of Claim 1. Thus, in the invention the integration of the output of the pulse width-pulse height multiplicator is periodically discontinued in the converter circuit producing the frequency signal, and as the integration is discontinued, the offset voltage is stored in the capacitor. When integration is resumed, the capacitor is again connected to the product circuit so that the effect of the offset voltage on the product current is compensated.

The invention is described in the following in detail by the aid of an embodiment example presented in the drawing, whereto the invention is not, however, intended to be exclusively confined. In the drawing

Figure 1 presents the block diagram of a static kWh meter known in the art.

Figure 2 presents the circuit diagram of the pulse width-pulse height multiplicator the subject matter of which is claimed in a copending application published 28.2.85 under WO 85/00893.

Figure 3 shows the wave forms occurring in the circuit of Figure 2.

Figures 4 and 4A illustrate the voltage/frequency converter in different operating modes.

Figure 5 shows the wave forms occurring in the converter of Figure 4.

Figure 6 presents the circuit diagram of the power source of the meter.

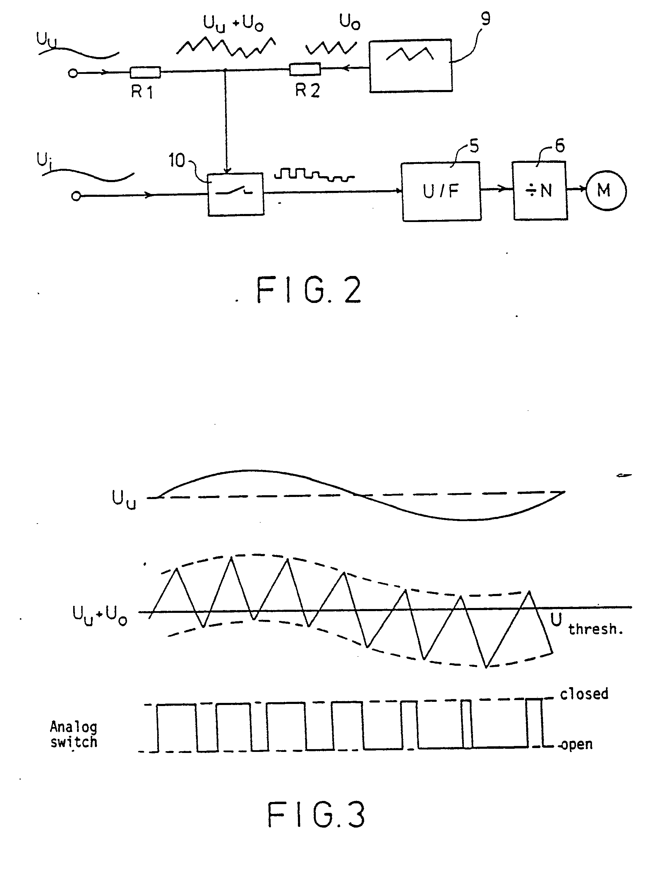

In Figure 2 is depicted the pulse width-pulse height multiplicator of a static kWh meter. The multiplicator comprises a summing circuit and a sampling switch controlled by the summed voltage. The summing circuit comprises two resistors R1, R2 joined by one end of each. To the other end of the first resistor R1 has been connected the signal $U_u$, which is proportional to the voltage, obtained from the measuring transformer 2 and to the other end of the second resistor R2 is carried the triangular wave $U_o$ from the triangular wave oscillator 9. The sum voltage $U_u+U_o$ is

obtained at the common point of the summing resistors R1, R2. The sampling switch 10 is analog switch receiving a signal $U_I$, proportional to the current intensity from the secondary circuit of the current measuring transformer 3, the control input of said switch being connected to the summing point. The analog switch 10, which may for instance be a J-FET or a MOS-FET, changes its state at a given threshold value $U_{thresh}$ of the control voltage. As shown in Figure 3, the threshold level $U_{thresh}$ of the analog switch 10 then determines the width of the sampling pulse in that the switch is closed when the sum wave $U_u+U_o$ is higher than the threshold level $U_{thresh}$, and open when the sum wave is lower than the threshold level. Hereby the output of the sampling switch controlled in such manner will be a square wave sequence in which the width of the pulses is proportional to the voltage and the height is proportional to the current. By the d.c. voltage obtained on filtering the pulse sequence, the voltage/frequency converter 5 is controlled.

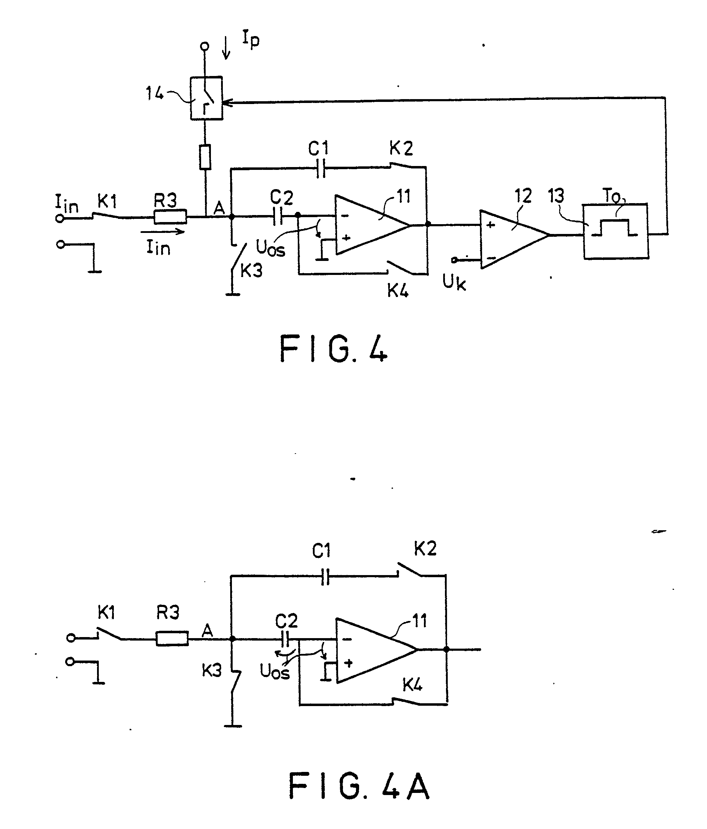

Figure 4 presents the voltage/frequency converter 5 of the meter depicted in Figure 1 and which has been provided with an offset voltage compensating circuit according to the invention. The voltage/frequency converter includes, in conventional manner, an operational amplifier 11 connected with the aid of a capacitor C1 and a resistor R3 to serve as integrator, a threshold level detector 12 controlled by the output of the integrator, and a timing circuit 13 whereby a constant current source connected to the output of the integrator is controlled. When the circuit is active, the integrator integrates the input current $I_{in}$ until the output of the integrator exceeds the threshold level $U_k$ of the comparator 12, when the timing circuit 13 starts to run and by the aid of a switch 14 switches a feedback current pulse $I_p$ for the duration $T_o$ to the input of the integrator. The operating frequency f of the converter is then found by the formula

$$I_{in} \cdot t = I_p \cdot T_o$$

$$f = \frac{1}{t} = \frac{I_{in}}{I_p \cdot T_o}$$

It is thus understood that the frequency f is directly proportional to the input current $I_{in}$, and therefore also to the input voltage $U_{in}$ because

$$I_{in} = \frac{U_{in} - U_{os}}{R_3}$$

For compensating the effect on the input current $I_{in}$ from the offset voltage $U_{os}$ of the amplifier 11, the voltage/frequency converter comprises according to the invention, a compensating arrangement which keeps the terminal on the side of the amplifier 11 of the resistor R3, or the point A in Figure 4, at zero level during integration. The compensating arrangement comprises a sampling switch K1 connecting the integrator to the multiplicator, a switch K2 in series with the integrating capacitor C1, and a compensating capacitor C2 between the point A and the inverting input of the amplifier 11, a switch K4 connecting the inverting input and the output of the amplifier 11, and a switch K3 grounding the point A.

The switches K1 and K2 allow the input current $I_{in}$ to be integrated when they are closed in the position as in Figure 4. During the integrating phase the switches K3 and K4 are open. For compensation, the integration is interrupted between the sampling periods of the sampling switch K1 by opening the switch K2 in series with the integrating capacitor C1. During the subsequent compensation phase, the output and inverting input of the amplifier 11 are connected by closing the switch K4, and the other terminal of the capacitor C2 is earthed by closing the switch K3, whereby the offset voltage $U_{os}$ of the amplifier 11 is charged into the compensating capacitor C2. During the compensation phase, the switches K1—K4 are thus controlled to be in the state as presented in Figure 4A. During the subsequent integration phase, the switches K1—K4 are again controlled to be in the state of Figure 4, whereby the compensating capacitor C2 is so connected to the input circuit that during the integration phase the voltage of the point A remains on zero level, which compensates for the effect of the offset voltage on the input current.

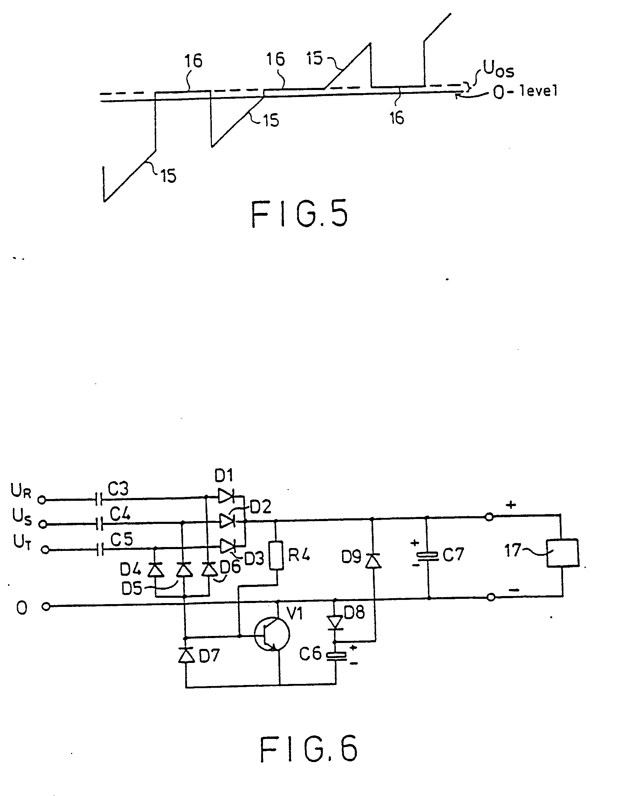

The resulting wave form of the output voltage of the integrator is shown in Figure 5, where the alternating integration phases and compensation phases respectively are seen as ascending parts 15 of the output voltage and as horizontal parts 16 corresponding to the offset voltage $U_{os}$.

Figure 6 presents the power source unit 8 providing the operating voltage for the circuits of a three-phase meter. The power source contains capacitors C3, C4, C5 for reducing the mains voltage $U_R$, $U_S$, $U_T$ and rectifying diodes D1—D6 and a filtering capacitor C7 for filtering the voltage supplied to the load 17. Since the circuits of the meter are required to operate also in the case that only one phase carries a voltage, the voltage reducing capacitors have to be dimensioned to be very large, in a conventional rectifying circuit. In order to avoid this, the power source of Figure 6 has moreover been provided with a circuit by the aid of which the current passing through the diodes during the negative half-periods of the phase that has remained live can be utilized. This circuit comprises a capacitor C6 which has been connected between the zero lead and the anodes of the rectifying diodes D4—D6 connected together, in series with the diodes D8 and D7 so that it can take up a charge during the negative half-cycles of the live phase through the forward diodes D7, D8. For discharging the charge of the capacitor C6 to the load 17 during the positive half-cycles of the live phase, the positive terminal of the capacitor C6 has been connected to the positive terminal of the load 17 over the diode D9, and the negative terminal of the capacitor C6 has been connected to the negative terminal of the load over the collector-emitter path of the transistor V1, the base of which has been connected to the common point of the diodes D7 and D4—D6 and over the resistor R4 to the cathodes of the diodes D1—D3. The voltage present across the diode D7 when the charging current of the capacitor C6 is flowing keeps the base voltage of the transistor V1 about 0.7V more negative than the emitter voltage, whereby the transistor is not conductive.

During the positive half-cycles the charging current of the capacitor C6 is interrupted. The base voltage of the transistor V1 will then increase to become more positive than the emitter voltage, by effect of the resistor R4. The transistor V1 becomes conductive and completes the discharge path of the capacitor C6. Hereby, the charge of the capacitor C6 is discharged through the diode D9 to the capacitor C7 and further to the load 17. During the positive half-cycles, current is moreover received through the diode D1. The discharge current of the capacitor C6 which is added to the said current will approximately double the current going to the load, and this enables the coupling capacitors C3, C4, C5 to be reduced to about one-half and, moreover, reduces the current drawn by the meter from the mains.

## Claims

1. A static kWh meter with members (2, 3) connected to the lead of the mains network for generating measuring signals ($U_u$, $U_1$) proportional to the voltage ($U_R$, $U_S$, $U_T$) and to the current ($I_R$, $I_S$, $I_T$), a pulse width-pulse height multiplicator circuit (1, 4) for forming a pulse width-pulse height-modulated signal representing the product of the measuring signals, an integrator (11, C1, R3) supplied by the output of the pulse width-pulse height multiplicator (1, 4) in a converter circuit (5), from which is obtained a frequency signal (f) proportional to the power, and a counting device (7) controlled by the frequency signal for determining the energy consumed, and a power source (8) connected to the leads of the mains for forming an operating voltage supplying said circuits, characterized in that the converter circuit (5) comprises first switch members (K1, K2) which allow the output of the pulse width-pulse height multiplicator (1, 4) to be integrated during fixed sampling periods, and that the input circuit of the integrator amplifier (11) contains a compensating capacitor (C2) in which the offset voltage ($U_{os}$) of the amplifier is stored by the aid of second switch members (K3, K4) operating between sampling periods, said capacitor (C2) being connected in series with the input of the integrator amplifier (11).

2. A kWh meter according to Claim 1, characterized in that the first switching members allowing integration comprise a sampling switch (K1) connecting the output of the pulse width-pulse height multiplicator to the input of the converter (5) and a switch (K2) in series with an integrating capacitor (C1), and the second switch members storing the offset voltage comprise a switch (K3) connecting the output and input of the amplifier (11) and a switch (K4) connecting one terminal (A) of the compensating capacitor (C2) to ground.

## Patentansprüche

1. Statischer kWh-Zähler mit Einrichtungen (2, 3), die mit der Leitung des Stromversorgungsnetzes verbunden sind und Maßsignale ($U_u$, $U_1$), erzeugen, die proportional zur Spannung ($U_R$, $U_S$, $U_T$) und zu dem Strom ($I_R$, $I_S$, $I_T$) sind, einer Impulsbreiten-Impulshöhen-Multiplikationsschaltung (1, 4) zur Erzeugung eines impulsebreiten-impulshöhen- modulierten Signals, welches das Produkt der Meßsignale darstellt, einem Integrator (11, C1, R3), dem in einer Umsetzschaltung (5), aus der ein zu der Leistung proportionales Frequenzsignal (f) erhalten wird, das Ausgangssignal der Impulsbreiten-Impulshöhen-Multiplikationsschaltung (1, 4) zugeführt wird, einer von dem Frequenzsignal gesteuerten Zähleinrichtung (7) zur Bestimmung der verbrauchten Energie, sowie mit einer Stromquelle (8), die mit den Leitungen des Netzes verbunden ist und eine Betriebsspannung zur Versorgung der Schaltungen erzeugt, dadurch gekennzeichnet, daß die Umsetzschaltung (5) erste Schalteinrichtungen (K1, K2) aufweist, die während festgelegter Abtastperioden die Integration des Ausgangssignals der Impulsbreiten-Impulshöhen-Multiplikationsschaltung (1, 4) erlauben, und daß die Eingangsschaltung des Integrationsverstärkers (11) einen kompensierenden Kondensator (C2) enhält, in welchem die Offset-Spannung ($U_{os}$) des Verstärkers mit Hilfe von zweiten Schalteinrichtungen (K3, K4), die zwischen den Abtastperioden arbeiten, gespeichert wird, wobei der Kondensator (C2) in Reihe mit dem Eingang des Integrationsverstärkers (11) verbunden ist.

2. kWh-Zähler nach Anspruch 1, dadurch gekennzeichnet, daß die ersten, die Integration erlaubende Schalteinrichtungen einen Abtastschalter (K1), der den Ausgang der Impulsbreiten-Impulshöhen-Multiplikationsschaltung mit dem Eingang des Umsetzers (5) verbindet, und einen Schalter (K2) aufweisen, der in Reihe zu einem integrierenden Kondensator (C1) liegt, und daß die zweiten, die Offset-Spannung speichernden Schalteinrichtungen einen Schalter (K3), der den Ausgang mit dem Eingang des Verstärkers (11) verbindet, und einen Schalter (K4) aufweisen, der einen Anschluß (A) des kompensierenden Kondensators (C2) mit Masse verbindet.

## Revendications

1. Un kilowattheuremètre statique cmportant des éléments (2, 3) connectés aux conducteurs du réseau électrique pour produire des signaux de mesure ($U_u$, $U_1$) proportionnels à la tension ($U_R$, $U_S$, $U_T$) et au courant ($I_R$, $I_S$, $I_T$), un circuit multiplicateur de largeur d'impulsion/hauteur d'impulsion (1, 4) destiné à produire un signal modulé en largeur d'impulsion et en hauteur d'impulsion, représentant le produit des signaux de mesure, un intégrateur (11, C1, R3) qui reçoit le signal de mesure, un intégrateur (11, C1, R3) qui reçoit le signal de sortie du multiplicateur de largeur d'impulsion/hauteur d'impulsion (1, 4) et qui fait partie d'un circuit convertisseur (5), qui fournit un signal de fréquence (f) proportionnel à la puissance, et un dispositif de comptage (7) qui est commandé par le signal de fréquence de façon à déterminer l'énergie consommée, et une source d'énergie (8) qui est connectée aux conducteurs du réseau électrique pour produire une tension d'alimentation qui alimente les circuits précités, caractérisé en ce que le circuit convertisseur (5) comprend des premiers éléments de commutation (K1, K2) qui permettent d'intégrer le signal de sortie du multiplicateur de largeur d'impulsion/hauteur d'impulsion (1, 4), pendant des périodes d'échantillonnage fixes, et en ce que le circuit d'entrée de l'amplificateur intégrateur (11) contient un condensateur de compensation (C2), dans lequel la tension de décalage ($U_{os}$) de l'amplificateur est mémorisée à l'aide de seconds éléments de commutation (K3, K4), qui fonctionnent entre des périodes d'échantillonnage, le condensateur précité (C2) étant connecté en série avec l'entrée de l'amplificateur intégrateur (11).

2. Un kilowattheuremètre selon la revendication 1, caractérisé en ce que les premiers éléments de commutation permettant l'intégration comprennent un interrupteur d'échantillonnage (K1) qui connecte la sortie du multiplicateur de largeur d'impulsion/hauteur d'impulsion à l'entrée du convertisseur (5), et un interrupteur (K2) en série avec un condensateur d'intégration (C1), et les seconds éléments de commutation qui mémorisent la tension de décalage comprennent un interrupteur (K3) qui connecte la sortie et l'entrée de l'amplificateur (11), et un interrupteur (K4) qui connecte une borne (A) du condensateur de compensation (C2) à la masse.

FIG.1

FIG. 2

FIG.3

FIG. 4

FIG. 4A

16    16   15

15

15

$U_{OS}$
0 - level

16        16

15

FIG.5

$U_R$ —○— C3          D1
$U_S$ —○— C4            D2
$U_T$ —○— C5

D4  D5  D6  D3  R4    D9    C7   17

D4    D6
D5

0 —○—

V1

D7    C6    D8

+
−

FIG.6